# EUROPÄISCHE PATENTSCHRIFT

(11) **EP 1 917 380 B1**
(45) Veröffentlichungstag und Bekanntmachung des Hinweises auf die Patenterteilung: **25.03.2009**
(21) Anmeldenummer: 06761238.2
(22) Anmeldetag: 24.07.2006
(51) Int. Cl.: C23C 14/50, F16M 13/00, B25B 11/00

(54) **WERKSTÜCK-TRÄGEREINRICHTUNG**
WORKPIECE SUPPORT SYSTEM
DISPOSITIF PORTE-PIECES

(30) Priorität: 29.08.2005 DE 102005041016; 25.01.2006 CH 1222006
(43) Veröffentlichungstag der Anmeldung: 07.05.2008
(73) Patentinhaber: Oerlikon Trading AG, Trübbach, 9477 Trübbach (CH)
(72) Erfinder: ESSER, Stefan, 52072 Aachen (DE)
(74) Vertreter: Wagner, Wolfgang Heribert
(86) Internationale Anmeldenummer: PCT/CH2006/000387
(87) Internationale Veröffentlichungsnummer: WO 2007/025397

(56) Entgegenhaltungen:
- EP-A- 1 153 155
- WO-A-99/33093
- DE-A1- 19 803 278
- DE-A1-9102004 027 98

## Beschreibung

### Technisches Gebiet

Die Erfindung betrifft eine Werkstückträgereinrichtung gemäss dem Oberbegriff des Anspruchs 1. Derartige Einrichtungen werden zur Bearbeitung von Werkstücken vor allem in Vakuumanlagen, insbesondere zur Beschichtung derselben verwendet.

### Stand der Technik

Eine gattungsgemässe Werkstückträgereinrichtung ist z.B. aus EP 1 153 155 A1 bekannt. Das Grundgestell ist dort um eine Hauptachse drehbar und wird von einem Elektromotor angetrieben. Zum Antrieb der Drehgestelle der mit gleichen Abständen um die Hauptachse verteilten Werkstückträger sind dieselben jeweils mit einem Zahnrad versehen, das mit einem unverdrehbaren die Hauptachse koaxial umgebenden Zahnkranz eingreift. Die an den Werkstückträgern drehbar gelagerten Werkstückhalter werden auf ähnliche Weise gedreht, indem jeweils ein Zahnrad am Werkstückhalter mit einem die Antriebsachse des Werkstückträgers koaxial umgebenden Zahnkranz eingreift, der dem Grundgestell gegenüber unverdrehbar ist.

Diese bekannte Werkstückträgereinrichtung ist verhältnismässig komplex aufgebaut. Die Zahnräder und Zahnkränze benötigen viel Platz und können die Beschichtung der Werkstücke in unerwünschter Weise beeinflussen. Ausserdem sind sie hohen Temperaturen und auch den für die Bearbeitung der Werkstücke eingesetzten Materialien ausgesetzt. Dies kann zu Funktionsstörungen, vor allem Blockierungen der Drehbewegungen führen. Aufgrund der gegebenen Abmessungen sind die Uebersetzungsverhältnisse nur innerhalb gewisser Grenzen wählbar, was zu einer unerwünscht raschen Drehung der Werkstückhalter zwingen kann. Dem ist allenfalls durch Zwischenübersetzungen zu steuern, was aber den Aufbau weiter kompliziert und den Platzbedarf erhöht, ausserdem die Reibung und das Risiko von Blockierungen vergrössert.

Bei einer der aus der DE 198 03 278 A1 ersichtlichen Werkstückträgereinrichtungen wird die Drehung der Werkstückhalter durch am Grundgestell verankerte Mitnehmer bewirkt, die mit denselben vorübergehend eingreifen. In diesem Fall ist die Drehung intermittierend, was an sich meist nachteilig ist und, vor allem wenn eine Beschichtung aus mehreren sehr dünnen Lagen angelegt wird, die Qualität der Werkstücke beeinträchtigen kann.

### Darstellung der Erfindung

Der Erfindung liegt die Aufgabe zu Grunde, eine gattungsgemässe Werkstückträgereinrichtung anzugeben, die einfach im Aufbau und zuverlässig ist. Diese Aufgabe wird durch die Merkmale im Kennzeichen des Anspruchs 1 gelöst.

Die durch die Erfindung erzielten Vorteil liegen vor allem darin, dass sie erlaubt, eine gattungsgemässe Werkstückträgereinrichtung mit zwei oder vorzugsweise drei Drehachsen sehr einfach und platzsparend aufzubauen. Der Antrieb der Werkstückhalter kann dadurch leicht so angeordnet werden, dass er die Bearbeitung der Werkstücke nicht beeihflusst. Umgekehrt kann er leicht davor geschützt werden, dass er den gleichen Einflüssen wie die Werkstücke ausgesetzt und dadurch beschädigt wird. Die Winkelgeschwindigkeit der Werkstückhalter kann mit verhältnismässig einfachen Mitteln über einen weiten Bereich eingestellt werden.

### Kurze Beschreibung der Zeichnungen

Im folgenden wird die Erfindung anhand von Figuren, welche lediglich Ausführungsbeispiele darstellen, näher erläutert.
Es zeigen
- Fig. 1: schematisch einen axialen Schnitt durch eine erfindungsgemässe Werkstückträgereinrichtung gemäss einer ersten Ausführungsform,
- Fig. 2: einen Ausschnitt aus Fig. 1,
- Fig. 3: eine Draufsicht auf den Ausschnitt gemäss Fig. 2,
- Fig. 4: teilweise geschnitten einen Teil der erfindungsgemässen Werkstückträgereinrichtung gemäss der ersten Ausführungsform,
- Fig. 5: einen.Teil eines Werkstückhalters der erfindungsgemässen Werkstückträgereinrichtung gemäss der ersten Ausführungsform,
- Fig. 6: einen Werkstückhalter gemäss einer abgewandelten Ausführung,
- Fig. 7: ein Uebertragerteil der erfindungsgemässen Werkstückträgereinrichtung gemäss der ersten Ausführungsform,
- Fig. 8: eine Draufsicht auf ein Vorgelegegetriebe der erfindungsgemässen Werkstückträgereinrichtung gemäss der ersten Ausführungsform,
- Fig. 9: einen Schnitt längs IX-IX in Fig. 8 durch das Vorgelegegetriebe und
- Fig. 10: schematisch einen axialen Schnitt durch eine erfindungsgemässe Werkstückträgereinrichtung gemäss einer zweiten Ausführungsform.

### Wege zur Ausführung der Erfindung

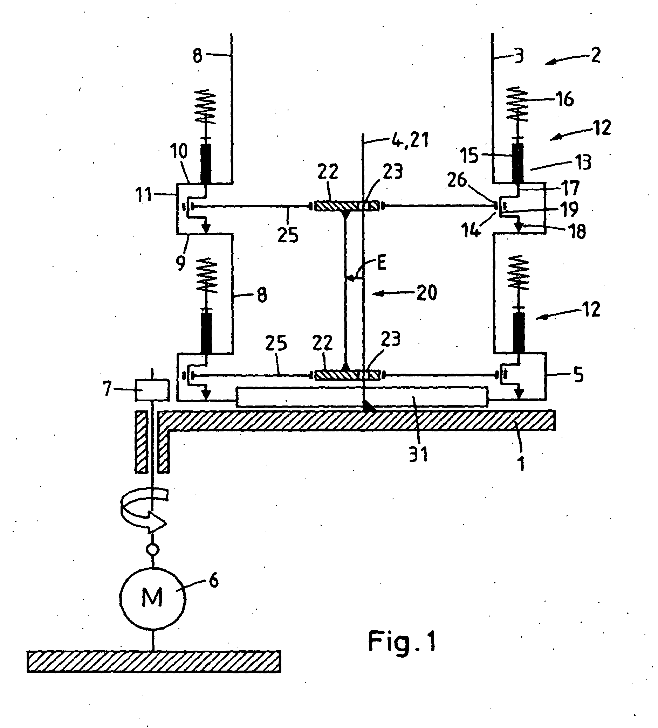

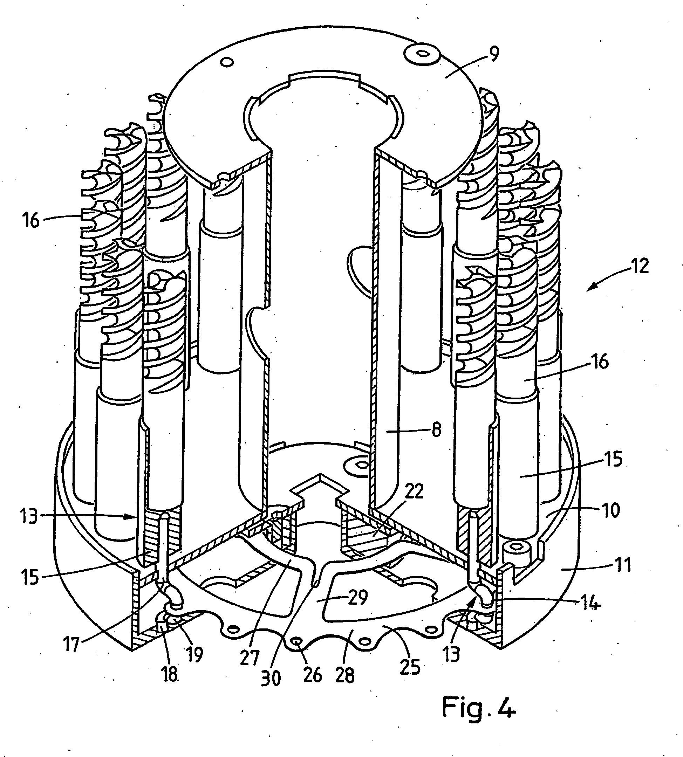

Gemäss einer ersten Ausführungsform einer erfindungsgemässen Werkstückträgereinrichtung ist (Fig. 1) auf einem feststehenden Grundgestell 1 ein Werkstückträger 2 (s. auch Fig. 4) angeordnet mit einem Drehgestell 3, das um eine senkrechte Antriebsachse 4 drehbar am Grundgestell 1 gelagert ist und am unteren Ende an seiner Aussenseite einen Zahnkranz 5 trägt (in Fig. 4 nicht dargestellt), mit welchem ein von einem Motor 6 angetriebenes Zahnrad 7 eingreift. Das Drehgestell 3 ist als um die Antriebsachse 4 annähernd rotationssymmetrisches geschlossenes Gehäuse ausgebildet mit zentralen Rohrabschnitten 8, zwischen denen längs der Antriebsachse 4 aufeinanderfolgende Auskragungen liegen, welche jeweils von einem kreisringförmigen Boden 9, einer ebensolchen Decke 10 und einem zu den Rohrabschnitten 8 konzentrischen Aussenring 11 gebildet werden, der mit dem Boden 9 einstückig an dessen Aussenrand anschliesst und den Aussenrand des Deckels 10 etwas überragt.

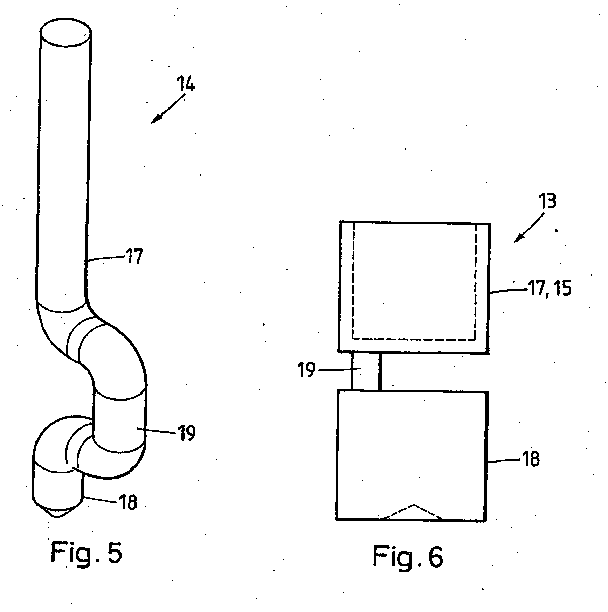

Das Drehgestell 3 trägt an jeder der besagten Auskragungen eine Gruppe 12 von Werkstückhaltern 13, die jeweils auf gleicher Höhe gleichmässig über einen die Antriebsachse 4 umgebenden Kreis verteilt sind. Jeder Werkstückhalter 13 ist um eine zur Antriebsachse 4 parallele Halterachse drehbar und umfasst (s. auch Fig. 5) eine Basis 14, die z.T. innerhalb einer Auskragung des Drehgestells 3 liegt und eine Halterung 15 zur Befestigung eines Werkstücks 16, welche auf einen mit der Basis 14 durch einen durch den Deckel 10 durchgeführten Achsstift 17 aufgesteckt ist. Weiter umfasst die Basis 14 einen Lagerstift 18 mit einer nach unten weisenden kegelförmigen Spitze, dessen Achse wie beim Achsstift 17 mit der Halterachse zusammenfällt und im Boden 9, wo die Spitze in eine entsprechende Ausnehmung eingreift, drehbar gelagert ist. Der Lagerstift 18 und der Achsstift 17 sind jeweils durch einen kurbelartigen Zwischenabschnitt verbunden, welcher einen zur Halterachse parallelen, aber von ihr beabstandeten Antriebsstift 19 umfasst. Die Basis 14 ist ein einfaches Biegeteil von im wesentlichen gleichbleibendem Querschnitt. Die aufgesteckte Halterung 15 weist eine oben offene zylindrische Ausnehmung auf, in welche das Werkstück 16, z.B. ein Fräskopf, eingesteckt wird.

Gemäss einer abgewandelten Ausführung (Fig. 6) sind der Achsstift 17 und der Lagerstift 18 jeweils im Verhältnis zur Höhe dicker, also zylindrisch ausgeführt, wobei der Achsstift 17 mit der Halterung 15 integriert ist und eine oben offene zylindrische Ausnehmung ausweist und der Lagerstift 18 an der Unterseite eine kegelförmige Ausnehmung, in die zur Lagerung ein entsprechender am Boden angebrachter Fortsatz eingreift. Der Antriebsstift 19 ist wiederum von der Halterachse beabstandet.

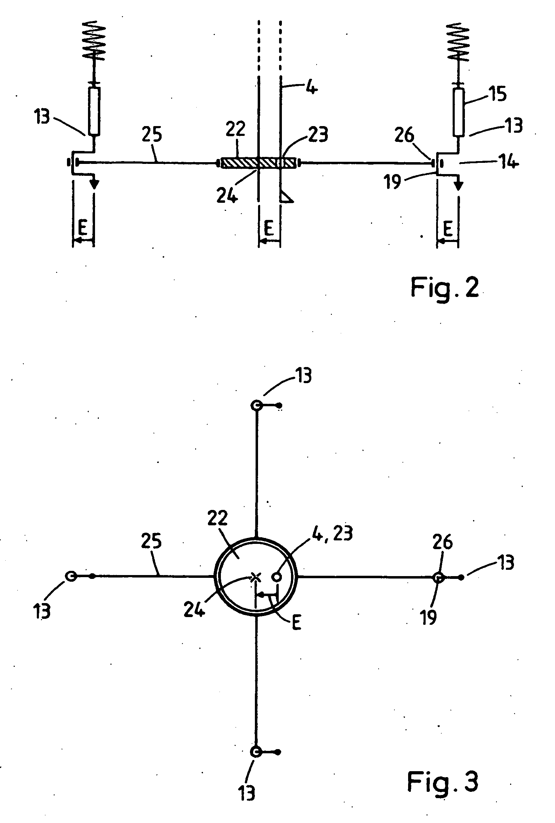

Ein gegenüber dem Drehgestell um die Antriebsachse 4 drehbares Antriebsteil 20 (in Fig. 4 nicht dargestellt) umfasst eine Welle 21, die z.B. als Vierkantstab ausgebildet ist und welche in der Antriebsachse 4 liegt und auf der Höhe jeder der Gruppen 12 eine Antriebsscheibe 22 trägt. Die Antriebsscheibe 22 ist waagrecht aufgerichtet, d.h. sie liegt in einer zur Welle 21, mit der sie unverdrehbar verbunden ist, normalen Ebene. Sie wird (s. auch Fig. 2, 3) von der Antriebsachse 4 an einem Verankerungspunkt 23 durchdrungen, von dem ihr Mittelpunkt als Abtriebspunkt 24 um eine Exzentrizität E beabstandet ist. Der Abstand des Antriebsstiftes 19 eines jeden Werkstückhalters 13 von der jeweiligen Halterachse entspricht ebenfalls jederzeit der Exzentrizität E, diese als in der zur Antriebsachse 4 normalen waagrechten Ebene mit dem Antriebsteil 20 kreisender Vektor betrachtet.

Jede der Antriebsscheiben 22 ist mit den Antriebsstiften 19 der auf ihrer Höhe liegenden Gruppe 12 von Werkstückhaltern 13 durch ein Uebertragerteil 25 verbunden, das eine kreisförmige zentrale Kopplungsausnehmung aufweist, deren Rand die Antriebsscheibe 22 knapp umgibt sowie mit für jeden Werkstückhalter 13 einer Antriebsöffnung 26, durch welche dessen Antriebsstift 19, von ihrem Rand knapp umgeben, ragt, sodass das Uebertragerteil 25 sowohl mit dem Antriebsteil 20 als auch mit den Werkstückhaltern 13 jeweils drehbar, aber im übrigen mit geringem Spiel verbunden ist. Ist die Basis 14 des Werkstückhalters 13 gemäss Fig. 5 ausgebildet, so kann sie sehr einfach in die Antriebsöffnung 26 eingefädelt und anschliessend die Halterung 15 aufgesteckt werden.

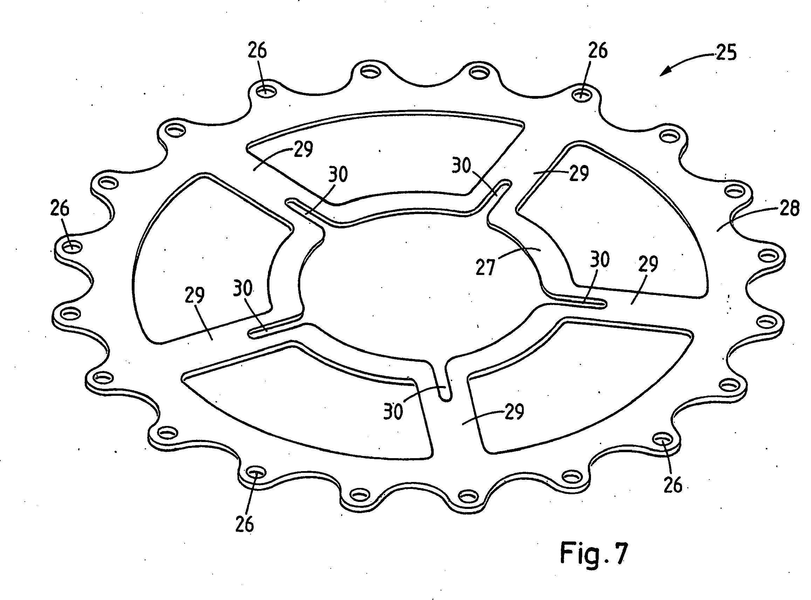

Das Uebertragerteil 25, das in Fig. 2, 3 nur schematisch dargestellt ist, kann (s. Fig. 7) als ebenes Stanzteil ausgebildet sein mit einem Innenring 27, der die besagte Kopplungsausnehmung umgibt und einem Aussenring 28, in dem die in diesem Fall zwanzig Antriebsöffnungen 26 für den Eingriff mit ebensovielen Werkstückhaltern 13 über den Umfang verteilt angebracht sind. Der Innenring 27 und der Aussenring 28 sind durch radiale Speichen 29 verbunden, welche, im Beispiel durch von der zentralen. Kopplungsausnehmung ausgehende radiale Schlitze 30, geschwächt sind, sodass sie Sollbruchstellen bilden, die im Fall einer Blockierung eines der Werkstückhalter 13 der entsprechenden Gruppe 12 brechen.

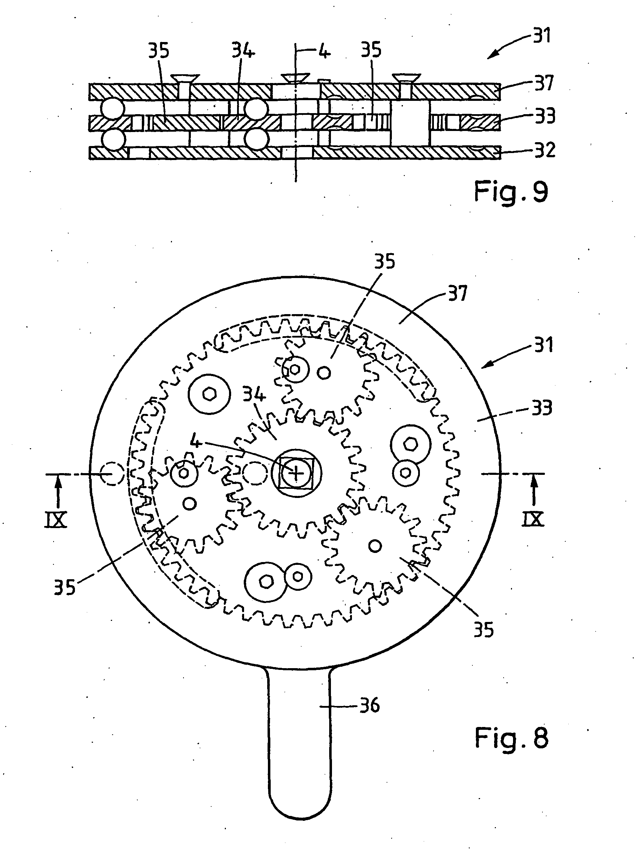

Die Welle 21 ist mit dem Abtrieb eines Vorgelegegetriebes 31 verbunden, welches am Grundgestell 1 befestigt ist. Es ist als Planetengetriebe ausgebildet (Fig. 8, 9) mit einer mit dem Grundgestell 1 verschraubten Grundplatte 32 und einem um die Antriebsachse 4 drehbar auf derselben gelagerten Zahnkranz 33 sowie einem unverdrehbar mit dem Abtrieb des Vorlegegetriebes 31 und somit mit der Welle 21 verbundenen Sonnenrad 34, das ebenfalls um die Antriebsachse 4 drehbar an der Grundplatte 32 gelagert ist. Es ist von drei gleichen Planetenrädern 35 umgeben, die um zur Antriebsachse 4 parallele Achsen drehbar sind und sowohl mit dem Zahnkranz 33 als auch mit dem Sonnenrad 34 eingreifen. Der Zahnkranz 33 weist einen nach aussen abstehenden stielartigen Fortsatz 36 auf, welcher bei Drehung des Drehgestells 3 an demselben anschlägt, sodass der Zahnkranz 33 bei weiterer Drehung des Drehgestells 3 in die gleiche Richtung demselben gegenüber unverdrehbar ist und mitgedreht wird. Der Fortsatz 36 bildet somit den Antrieb des Vorgelegegetriebes 31. Das Vorlegegetriebe 31 ist ausserdem durch eine mit der Grundplatte 32 verschraubte Deckplatte 37 mit einer mittigen Oeffnung für die Welle 21 verschlossen.

Wird das Drehgestell 3 durch den Motor 6 um die Antriebsachse 4 gedreht, so wird der Fortsatz 36 mitgenommen und der Zahnkranz 33 des Vorgelegegetriebes 31 mitgedreht, sodass auch das Antriebsteil 20 um die Antriebsachse 4 gedreht wird, und zwar mit einer entsprechend dem Uebersetzungsverhältnis des Vorlegegetriebes 31, das aus einem weiten Bereich gewählt werden kann, grösseren Winkelgeschwindigkeit. Durch jede der exzentrisch an der welle 21 befestigten Antriebsscheiben 22 wird jeweils das mit ihr zusammenwirkende Uebertragerteil 25 ebenfalls einer Kreisbewegung mit einem der Länge der Exzentrizität E entsprechenden Radius unterworfen, wobei es jedoch wegen seines Eingriffs mit den Antriebsstiften 19 der Werkstückhalter 13 der entsprechenden Gruppe 12 nicht mitgedreht wird. Die Antriebsstifte 19 werden von der Bewegung des Uebertragerteils 25 mitgenommen und führen ebenfalls eine Kreisbewegung mit einem der Länge der Exzentrizität E entsprechenden Radius um die jeweiligen Halterachsen aus, was eine entsprechende Drehung der Werkstückhalter 13 um dieselben bewirkt.

Die Ausbildung des geschilderten ersten Ausführungsbeispiels kann in vieler Hinsicht abgewandelt werden, ohne dass das Gebiet der Erfindung verlassen würde. So können zur Verbindung der Welle mit dem Uebertragerteil statt Antriebsscheiben auch Kurbeln vorgesehen sein, welche jeweils unverdrehbar.mit der Welle und drehbar mit dem entsprechenden Uebertragerteil verbunden sind, insbesondere kann die Welle kurbelartige Ausbiegungen aufweisen ähnlich wie der Werkstückhalter gemäss Fig. 5. Auch das Uebertragerteil könnte anders, z.B. sternförmig ausgebildet sein. Entscheidend ist, dass ein um die Antriebsachse drehbares exzentrisches Antriebsteil vorhanden ist, d.h.., ein Antriebsteil, das einen exzentrischen Abtriebspunkt aufweist, an dem es mit dem Uebertragerteil drehbar eingreift, während das Uebertragerteil mit einem in gleicher Weise exzentrischen Antriebspunkt am jeweiligen Werkstückhalter ebenfalls drehbar eingreift. Die Zahl der über ein Uebertragerteil angetriebenen Werkstückhalter kann über einen weiten Bereich variieren, doch sollte jedes Uebertragerteil mit mindestens zweien eingreifen, damit es keine unkontrollierten Bewegungen ausführen kann. Die Werkstückhalter können auch in verschiedenen Abständen von der Antriebsachse angeordnet sein, was eine dichtere Anordnung ermöglicht. Es ist auch möglich, die Werkstückhalter jeder zweiten Gruppe nach unten zu richten, derart, dass ihre Halterungen gegen diejenigen der nächstunteren Gruppe weisen und jeweils die einen oder die anderen Halterungen zu federn, sodass Werkstücke, die anders schwer zu fixieren sind, jeweils zwischen einer unteren und einer oberen Halterung geklemmt werden können.

Die Verbindung zwischen dem Antriebsteil und dem Uebertragerteil kann auch über Kugellager hergestellt sein, desgleichen die Verbindung zwischen dem Uebertragerteil und den Werkstückhaltern, insbesondere den Antriebsstiften derselben. Das Vorgelegegetriebe kann durch einen separaten Antrieb ersetzt sein oder es kann auch das Antriebsteil direkt am Grundgestell verankert sein, allerdings bleibt dann die Orientierung der Werkstücke, während sie um die Antriebsachse kreisen, relativ zum Grundgestell gleich. Es können auch andere oder zusätzliche Sollbruchstellen vorgesehen sein, z.B. an der Verbindung zwischen der Welle einerseits und jeder der Antriebsscheiben oder -kurbeln andererseits oder an jedem Werkstückhalter oder seiner Verbindung mit dem Uebertragerteil. Die Ausbildung des Drehgestells als eines geschlossenen Gehäuses hat den Vorteil, dass es den Antriebsmechanismus vor den Einwirkungen, denen die Werkstücke ausgesetzt sind, schützt, doch sind andere Ausführungen deswegen nicht ausgeschlossen. Schliesslich können mehrere Drehgestelle um das Zahnrad herum angeordnet und über dasselbe von einem gemeinsamen Motor angetrieben werden.

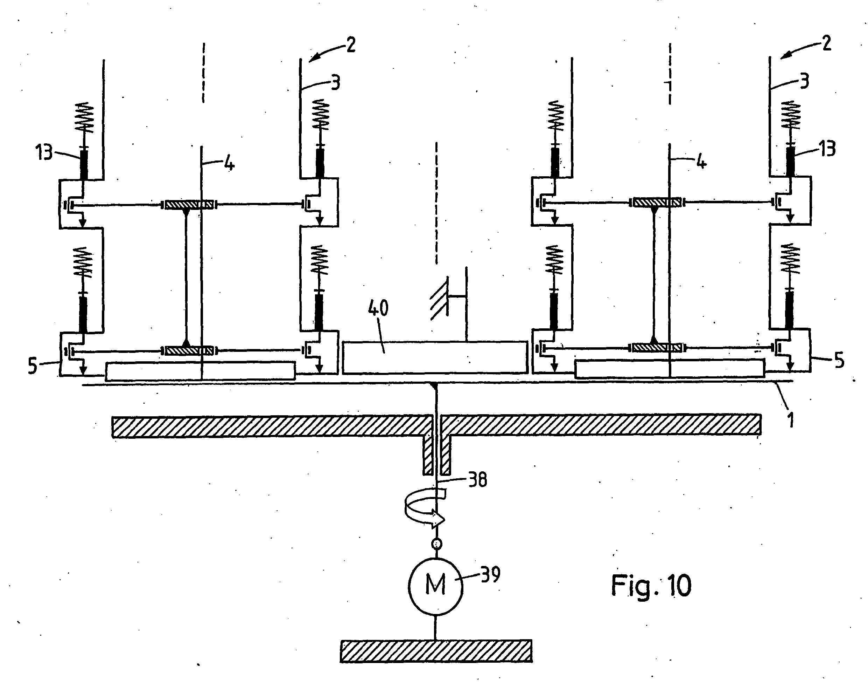

Eine zweite Ausführungsform einer erfindungsgemässen Werkstückträgereinrichtung ist aus Fig. 10 ersichtlich. Hier sind mehrere dem im Zusammenhang mit dem ersten Ausführungsbeispiel beschriebenen entsprechende Werkstückträger 2 um eine Hauptachse 38 herum angeordnet, um die das Grundgestell 1 durch einen Motor 39 drehbar ist. Die Zahnkränze 5 greifen mit einem ortsfesten Zahnrad 40 ein. Drehung des Grundgestells 1 bewirkt durch den Eingriff der Zahnkränze 5 mit dem Zahnrad 40, dass sich jedes der Drehgestelle 3 um die jeweilige Antriebsachse 4 dreht, während die Werkstückträger 2 um die Hauptachse 38 kreisen. Die Werkstückträger 2 bilden somit in an sich bekannter, Weise um die Hauptachse 38 kreisende Planetenelemente, die ihrerseits von den sich drehenden Werkstückhaltern 13 als Mondelementen umkreist werden, wobei ein einziger Antrieb sämtliche Bewegungen bewirkt. Im übrigen entspricht die Funktion der Werkstückträger 2 genau dem im Zusammenhang mit dem ersten Ausführungsbeispiel Beschriebenen. Die dort angegebenen Abweichungen der Ausbildung der Werkstückträger vom dargestellten Beispiel sind hier ebenfalls möglich.

### Bezugszeichenliste

- 1: Grundgestell
- 2: Werkstückträger
- 3: Drehgestell
- 4: Antriebsachse
- 5: Zahnkranz
- 6: Motor
- 7: Zahnrad
- 8: Rohrabschnitt
- 9: Boden
- 10: Deckel
- 11.: Aussenring
- 12: Gruppe
- 13: Werkstückhalter
- 14: Basis
- 15: Halterung
- 16: Werkstück
- 17: Achsstift
- 18: Lagerstift
- 19: Antriebsstift
- 20: Antriebsteil
- 21: Welle
- 22: Antriebsscheibe
- 23: Verankerungspunkt
- 24: Abtriebspunkt
- 25: Uebertragerteil
- 26: Antriebsöffnung
- 27: Innenring
- 28: Aussenring
- 29: Speiche
- 30: Schlitz
- 31: Vorgelegegetriebe
- 32: Grundplatte
- 33: Zahnkranz
- 34: Sonnenrad
- 35: Planetenrad
- 36: Fortsatz
- 37: Deckplatte
- 38: Hauptachse
- 39: Motor
- 40: Zahnrad

## Patentansprüche

1. Werkstückträgereinrichtung mit mindestens einem Werkstückträger (2), welcher ein um eine Antriebsachse (4) drehbar an einem Grundgestell (1) gelagertes Drehgestell (3) und ein ebenfalls um die Antriebsachse (4) dem Drehgestell (3) gegenüber drehbares Antriebsteil (20) sowie mehrere von der Antriebsachse (4) beabstandete und um zu derselben parallele Halterachsen drehbar am Drehgestell (3) gelagerte Werkstückhalter (13) umfasst, **dadurch gekennzeichnet, dass** zur Drehung der Werkstückhalter (13) gegenüber dem Drehgestell (3) mindestens ein starres Uebertragerteil (25) vorgesehen ist, das einerseits mit dem Antriebsteil (20) an einem von der Antriebsachse (4) um eine Exzentrizität (E) beabstandeten Abtriebspunkt (24) und andererseits mit mindestens zwei Werkstückhaltern (13) jeweils an einem um eine gleiche Exzentrizität (E) von der Halterachse beabstandeten Antriebspunkt drehbar eingreift.

2. Werkstückträgereinrichtung nach Anspruch 1, **dadurch gekennzeichnet, dass** das Antriebsteil (20) eine senkrecht zur Antriebsachse (4) ausgerichtete Antriebsscheibe (22) umfasst, deren Mittelpunkt den Abtriebspunkt (24) bildet und welche an einem auf der Antriebsachse (4) liegenden Verankerungspunkt (23) gehaltert ist, während das Uebertragerteil (25) eine kreisförmige Kopplungsausnehmung aufweist, deren Rand die Antriebsscheibe (22) umgibt.

3. Werkstückträgereinrichtung nach Anspruch 1 oder 2, **dadurch gekennzeichnet, dass** jeder Werkstückhalter (13) einen zur Halterachse parallelen Antriebsstift (19) runden Querschnitts umfasst, welcher mit einer entsprechenden Antriebsöffnung (26) am Uebertragerteil (25) eingreift.

4. Werkstückträgereinrichtung nach einem der Ansprüche 1 bis 3, **dadurch gekennzeichnet, dass** jeder Werkstückhalter (13) eine Basis (14), an welcher der Antriebspunkt liegt, mit einem um die Halterachse drehbar am Drehgestell (3) gelagerten Achsstift (17) aufweist sowie eine Halterung (15) zur Befestigung des Werkstücks (16), welche am Achsstift (17) angebracht ist.

5. Werkstückträgereinrichtung nach den Ansprüchen 3 und 4, **dadurch gekennzeichnet, dass** die Basis (14) jedes Werkstückhalters (13) einen Lagerstift (18) umfasst, welcher um die Halterachse drehbar am Drehgestell (3) gelagert ist sowie einen kurbelartig seitlich ausgebogenen Zwischenabschnitt, der den Lagerstift (18) mit dem Achsstift (17) verbindet und welcher den Antriebsstift (19) enthält.

6. Werkstückträgereinrichtung nach Anspruch 4 oder 5, **dadurch gekennzeichnet, dass** das Drehgestell (3) als geschlossenes Gehäuse ausgebildet ist, welches das Antriebsteil (20) und jedes Uebertragerteil (25) umschliesst, ausserdem den Teil der Basis (14) jedes der Werkstückhalter (13), an dem der Antriebspunkt liegt, während der Achsstift (17) derselben durch das Gehäuse nach aussen geführt ist.

7. Werkstückträgereinrichtung nach einem der Ansprüche 1 bis 6, **dadurch gekennzeichnet, dass** der Werkstückträger (2) eine Gruppe (12) von Werkstückhaltern (13) umfasst, welche auf gleicher Höhe um die Antriebsachse (4) herum angeordnet sind sowie ein Uebertragerteil (25), welches mit allen Werkstückhaltern (13) der Gruppe (12) eingreift.

8. Werkstückträger nach einem der Ansprüche 3 bis 6 und Anspruch 7, **dadurch gekennzeichnet, dass** die Werkstückhalter (13) der Gruppe (12) gleichmässig über einen die Antriebsachse (4) umgebenden Kreis verteilt sind und das Uebertragerteil (25) einen Ring mit entsprechend über dieselben verteilten Antriebsöffnungen (26) umfasst.

9. Werkstückträgereinrichtung nach Anspruch 7 oder 8, **dadurch gekennzeichnet, dass** der Werkstückträger (2) mehrere längs der Antriebsachse (4) verteilte Gruppen (12) von Werkstückhaltern (13) umfasst.

10. Werkstückträgereinrichtung nach einem der Ansprüche 1 bis 9, **dadurch gekennzeichnet, dass** das Antriebsteil (20) derart mit dem Grundgestell (1) wirkverbunden ist, dass es sich bei Drehung des Drehgestells (3) mit einer von der desselben abweichenden Winkelgeschwindigkeit gegenüber dem Grundgestell (1) dreht.

11. Werkstückträgereinrichtung nach Anspruch 10, **dadurch gekennzeichnet, dass** das Antriebsteil (20) mit einem Abtrieb eines am Grundgestell (1) verankerten Vorgelegegetriebes (31) unverdrehbar verbunden ist, dessen Antrieb mit dem Drehgestell (3) derart verbunden ist, dass er von dessen Drehbewegung mitgenommen wird.

12. Werkstückträgereinrichtung nach Anspruch 11, **dadurch** gekenntzeichnet, dass das Vorgelegegetriebe (31) als Planetengetriebe ausgebildet ist mit einem mit dem Antrieb verbundenen Zahnkranz (33), einem mit dem Abtrieb verbundenen, vom Zahnkranz (33) koaxial umgebenen Sonnenrad (34) sowie mit mindestens einem Planetenrad (35), das mit dem Zahnkranz (33) und mit dem Sonnenrad (34) eingreift.

13. Werkstückträgereinrichtung nach einem der Ansprüche 10 bis 12, **dadurch gekennzeichnet, dass** sie mehrere Werkstückträger (2) umfasst, deren Antriebsachsen (4) zu einer Hauptachse (38), um welche das Grundgestell (1) drehbar ist, parallel sind.

14. Werkstückträgereinrichtung nach Anspruch 13, **dadurch gekennzeichnet, dass** die Werkstückträger (2) die Hauptachse (38) umgeben und das Drehgestell (3) jedes Werkstückträgers (2) einen Zahnkranz (5) trägt, welcher mit einem zur Hauptachse (38) koaxialen ortsfesten Zahnrad (40) eingreift.

## Claims

1. A workpiece carrier device having at least one workpiece carrier (2) which comprises a rotary frame (3), mounted on a base frame (1) so as to be rotatable about a driving axle (4), and a driving part (20) which is likewise rotatable about the driving axle (4) in relation to the rotary frame (3), as well as a plurality of workpiece holders (13) which are at a distance from the driving axle (4) and are mounted on the rotary frame (3) so as to be rotatable about holder axes that are parallel to said driving axle (4), **characterized in that**, for the purpose of rotating the workpiece holders (13) in relation to the rotary frame (3) of those workpiece holders (13), there is provided at least one rigid transmission part (25) which engages rotatably with, on the one hand, the driving part (20) at an output point (24) which is at a distance of an eccentricity (E) from the driving axle (4), and, on the other hand, at least two workpiece holders (13) each at a drive point at a distance of an equal eccentricity (E) from the holder axis.

2. The workpiece carrier device according to claim 1, **characterized in that** the driving part (20) comprises a driving disc (22) which is aligned perpendicularly relative to the driving axle (4) and whose centre point constitutes the output point (24), and which is mounted at an anchorage point (23) located on the driving axle (4), whilst the transmission part (25) has a circular coupling cutout whose edge surrounds the driving disc (22).

3. The workpiece carrier device according to either of claims 1 or 2, **characterized in that** each workpiece holder (13) comprises a driving pin (19), of round cross-section, which is parallel to the holder axis and which engages with a corresponding driving aperture (26) on the transmission part (25).

4. The workpiece carrier device according to any one of claims 1 to 3, **characterized in that** each workpiece holder (13) has a base (14), at which the drive point is located, with an axle pin (17) mounted on the rotary frame (3) so as to be rotatable about the holder axis, and has a mount (15), which is mounted on the axle pin (17), for securing the workpiece (16).

5. The workpiece carrier device according to claims 3 and 4, **characterized in that** the base (14) of each workpiece holder (13) comprises a bearing pin (18) which is mounted on the rotary frame (3) so as to be rotatable about the holder axis, and an intermediate portion bent outwards laterally in the manner of a crank, which connects the bearing pin (18) to the axle pin (17) and includes the driving pin (19).

6. The workpiece carrier device according to either of claims 4 or 5, **characterized in that** the rotary frame (3) is realized as a closed housing which surrounds the driving part (20) and each transmission part (25), and also the portion of the base (14) of each of the workpiece holders (13) at which the drive point is located, whilst the axle pin (17) of said workpiece holders (13) is brought outwards through the housing.

7. The workpiece carrier device according to any one of claims 1 to 6, **characterized in that** the workpiece carrier (2) comprises a group (12) of workpiece holders (13) which are disposed at the same level around the driving axle (4), as well as a transmission part (25) which engages with all workpiece holders (13) of the group (12).

8. The workpiece carrier according to any one of claims 3 to 6 and claim 7, **characterized in that** the workpiece holders (13) of the group (12) are distributed uniformly over a circle surrounding the driving axle (4), and the transmission part (25) comprises a ring with driving apertures (26) distributed in corresponding manner over the same.

9. The workpiece carrier device according to either of claims 7 or 8, **characterized in that** the workpiece carrier (2) comprises a plurality of groups (12) of workpiece holders (13) distributed along the driving axle (4).

10. The workpiece carrier device according to any one of claims 1 to 9, **characterized in that** the driving part (20) is operatively connected to the base frame (1) in such a way that, upon rotation of the rotary frame (3), it rotates in relation to the base frame (1) at an angular velocity which differs from that of said rotary frame (3).

11. The workpiece carrier device according to claim 10, **characterized in that** the driving part (20) is connected in a torsionally rigid manner to an output of an auxiliary gear set (31) anchored on the base frame (1), the drive of which said auxiliary gear set (31) is connected to the rotary frame (3) in such a way that it is concomitantly driven by the rotary motion of the latter.

12. The workpiece carrier device according to claim 11, **characterized in that** the auxiliary gear set (31) is realized as a planetary gear set, with a ring gear (33) connected to the drive, a sun gear (34) which is connected to the output and coaxially surrounded by the ring gear (33), and with at least one planetary gear (35) which engages with the ring gear (33) and with the sun gear (34).

13. The workpiece carrier device according to any one of claims 10 to 12, **characterized in that** it comprises a plurality of workpiece carriers (2) whose driving axles (4) are parallel to a main axle (38) about which the base frame (1) is rotatable.

14. The workpiece carrier device according to claim 13, **characterized in that** the workpiece carriers (2) surround the main axle (38), and the rotary frame (3) of each workpiece carrier (2) carries a ring gear (5) which engages with a stationary toothed wheel (40) which is coaxial with the main axle (38).

## Revendications

1. Dispositif porte-pièce comprenant au moins un porte-pièce (2) qui comporte un bâti tournant (3) monté sur un bâti de base (1) de manière à pouvoir tourner autour d'un axe d'entraînement (4) et une pièce d'entraînement (20) pouvant tourner également autour de l'axe d'entraînement (4) par rapport au bâti tournant (3), ainsi que plusieurs dispositifs de fixation de pièce (13) distants de l'axe d'entraînement (4) et montés sur le bâti de rotation (3) de manière à pouvoir tourner autour d'axes parallèles audit axe d'entraînement, **caractérisé en ce qu'**il est prévu, pour la rotation des dispositifs de fixation de pièce (13) par rapport au bâti tournant (3), au moins une pièce de transmission (25) fixe qui vient en prise de manière à pouvoir tourner avec la pièce d'entraînement (20) en un point de sortie (24) distant de l'axe d'entraînement (4) d'une excentricité (E), d'une part, et avec au moins deux dispositifs de fixation de pièce (13) chacun en un point d'entraînement distant de l'axe de fixation d'une même excentricité (E), d'autre part.

2. Dispositif porte-pièce selon la revendication 1, **caractérisé en ce que** la pièce d'entraînement (20) comprend une poulie d'entraînement (22) orientée perpendiculairement à l'axe d'entraînement (4), dont le centre forme le point de sortie (24) et qui est fixée en un point d'ancrage (23) situé sur l'axe d'entraînement (4), tandis que la pièce de transmission (25) présente un évidement d'accouplement de forme circulaire dont le bord entoure la poulie d'entraînement (22).

3. Dispositif porte-pièce selon la revendication 1 ou 2, **caractérisé en ce que** chaque dispositif de fixation de pièce (13) comprend une broche d'entraînement (19) de section transversale ronde parallèle à l'axe de fixation qui est en prise avec un orifice d'entraînement correspondant (26) sur la pièce de transmission (25).

4. Dispositif porte-pièce selon l'une quelconque des revendications 1 à 3, **caractérisé en ce que** chaque dispositif de fixation de pièce (13) présente une base (14) sur laquelle le point d'entraînement se trouve, avec une broche d'axe (17) montée sur le bâti tournant (3) de manière à pouvoir tourner autour de l'axe de fixation, ainsi qu'une fixation (15) destinée à maintenir la pièce (16) qui est placée sur la broche d'axe (17).

5. Dispositif porte-pièce selon les revendications 3 et 4, **caractérisé en ce que** la base (14) de chaque dispositif de fixation de pièce (13) comprend une broche de palier (18) qui est montée sur le bâti tournant (3) de manière à pouvoir tourner autour de l'axe de fixation, ainsi qu'un segment intermédiaire coudé latéralement en forme de vilebrequin qui relie la broche de palier (18) à la broche d'axe (17) et qui contient la broche d'entraînement (19).

6. Dispositif porte-pièce selon la revendication 4 ou 5, **caractérisé en ce que** le bâti tournant (3) est réalisé sous la forme d'un carter fermé qui enferme la pièce d'entraînement (20) et chaque pièce de transmission (25), en outre la partie de la base (14) de chacun des dispositifs de fixation de pièce (13) sur laquelle se trouve le point d'entraînement, tandis que la broche d'axe (17) de ladite base est guidée vers l'extérieur à travers le carter.

7. Dispositif porte-pièce selon l'une quelconque des revendications 1 à 6, **caractérisé en ce que** le porte-pièce (2) comprend un groupe (12) de dispositifs de fixation de pièce (13) qui sont disposés à la même hauteur autour de l'axe d'entraînement (4), ainsi qu'une pièce de transmission (25) qui vient en prise avec tous les dispositifs de fixation de pièce (13) du groupe (12).

8. Porte-pièce selon l'une quelconque des revendications 3 à 6 et la revendication 7, **caractérisé en ce que** les dispositifs de fixation de pièce (13) du groupe (12) sont répartis régulièrement sur un cercle entourant l'axe d'entraînement (4) et la pièce de transmission (25) comprend un anneau avec des orifices d'entraînement (26) répartis de manière correspondante sur celui-ci.

9. Dispositif porte-pièce selon la revendication 7 ou 8, **caractérisé en ce que** le porte-pièce (2) comprend plusieurs groupes (12) de dispositifs de fixation de pièce (13) répartis le long de l'axe d'entraînement (4) .

10. Dispositif porte-pièce selon l'une quelconque des revendications 1 à 9, **caractérisé en ce que** la pièce d'entraînement (20) est reliée de manière active avec le bâti de base (1), de telle sorte qu'elle tourne par rapport au bâti de base (1) lors de la rotation du bâti tournant (3) à une vitesse angulaire différente de celle de celui-ci.

11. Dispositif porte-pièce selon la revendication 10, **caractérisé en ce que** la pièce d'entraînement (20) est reliée de manière à ne pas pouvoir tourner à une sortie d'un engrenage intermédiaire (31) ancré sur le bâti de base (1), dont l'entraînement est relié au bâti tournant (3) de telle sorte qu'il est entraîné par le mouvement de rotation de celui-ci.

12. Dispositif porte-pièce selon la revendication 11, **caractérisé en ce que** l'engrenage intermédiaire (31) est réalisé sous la forme d'un engrenage planétaire avec une couronne dentée (33) reliée à l'entraînement, une roue solaire (34) reliée à la sortie, entourée coaxialement par la couronne dentée (33) ainsi qu'avec au moins une roue planétaire (35) qui vient en prise avec la couronne dentée (33) et avec la roue solaire (34).

13. Dispositif porte-pièce selon l'une quelconque des revendications 10 à 12, **caractérisé en ce qu'**il comprend plusieurs porte-pièce (2) dont les axes d'entraînement (4) sont parallèles à un axe principal (38) autour duquel le bâti de base (1) peut tourner.

14. Dispositif porte-pièce selon la revendication 13, **caractérisé en ce que** les porte-pièce (2) entourent l'axe principal (38) et le bâti tournant (3) de chaque porte-pièce (2) porte une couronne dentée (5) qui vient en prise avec une roue dentée (40) stationnaire coaxiale à l'axe principal (38).
